# EUROPEAN PATENT SPECIFICATION

(11) **EP 4 086 561 B1**
(45) Date of publication and mention of the grant of the patent: **01.05.2024**
(21) Application number: 20910596.4
(22) Date of filing: 30.12.2020
(51) Int. Cl.: F28F 3/08, F28D 9/00

(54) **CHIP, CHIP ASSEMBLY, CORE AND INTERCOOLER**
CHIP, CHIPANORDNUNG, KERN UND ZWISCHENKÜHLER
PUCE, ENSEMBLE PUCE, NOYAU ET REFROIDISSEUR INTERMÉDIAIRE

(30) Priority: 31.12.2019 CN 201911412749
(43) Date of publication of application: 09.11.2022
(73) Proprietor: Zhejiang Yinlun Machinery Co., Ltd., Tiantai County, Zhejiang 317200 (CN)
(72) Inventor: LI, Tian, Zhejiang 317200 (CN); TANG, Pingqiang, Zhejiang 317200 (CN); XIE, Jian, Zhejiang 317200 (CN); LIU, Weifeng, Zhejiang 317200 (CN); XIE, Xianlong, Zhejiang 317200 (CN); CHEN, Xiaofeng, Zhejiang 317200 (CN); WANG, Qiang, Zhejiang 317200 (CN); WANG, Qing, Zhejiang 317200 (CN)
(74) Representative: Kolster Oy Ab
(86) International application number: PCT/CN2020/141663
(87) International publication number: WO 2021/136437

(56) References cited:
- EP-A1- 3 489 604
- EP-A1- 3 546 257
- CN-A- 107 782 179
- CN-A- 110 375 573
- CN-A- 111 029 316
- CN-U- 211 238 221
- FR-A1- 2 855 604
- KR-A- 20010 108 765
- US-A1- 2014 216 700
- US-A1- 2018 058 306

## Description

### Technical Field

The present disclosure relates to the technical field of heat exchange devices, and in particular, to a chip (core sheet), a chip assembly, a core (core body) and an intercooler.

### Background Art

A cooled medium flow channel and a cooling liquid flow channel are formed in a core of the intercooler, wherein the cooled medium flow channel is used for the circulation of the medium (such as high temperature gas) that needs to be cooled, and the cooling liquid flow channel is used for the circulation of the cooling liquid, and the core is usually formed by stacking chips, for the two side plate surfaces of the chip, a high temperature gas flow channel is formed on one side, and a cooling liquid flow channel is formed on the other side, and mediums on two sides of the chip exchange heat through the chip. However, the intercooler in the related art has poor heat exchange performance.

Prior art document US 2018/058306 shows a heat exchanger with a flange, protrusion and blocking part configured to blocking cooling medium. FR 2855604, US 2014/216700 and EP 2546257 show similar arrangements.

### Summary

The purpose of the present disclosure includes providing a chip, a chip assembly, a core and an intercooler, so as to improve the problem of poor heat exchange performance of the intercooler in the related art.

In order to achieve the above purpose, the present disclosure uses the following technical solutions.

One aspect of the present disclosure provides a chip, the chip has a first flange and a first plate surface configured to be in contact with a cooled medium, the first flange is formed on the first plate surface and extends in a first direction;
a protrusion part and a cooled medium flow channel are formed on the first plate surface, the protrusion part is located between the first flange and the cooled medium flow channel in a second direction, and a blocking part configured to block the cooled medium is formed between the first flange and the protrusion part; and
the first direction is an extension direction of the cooled medium flow channel, and the second direction is parallel to the first plate surface and is perpendicular to the first direction.

The blocking part has one end connected to the first flange, and the other end connected to the protrusion part, in the second direction.

The beneficial effect of the technical solution is that most of the cooled medium flowing to between the first flange and the protrusion part can be blocked by the blocking part, and the proportion of the cooled medium that flows and deviates from the cooled medium flow channel is further reduced.

Optionally, the blocking part is formed at the first flange.

The beneficial effect of the technical solution is that the blocking part and the first flange are in an integrally-formed structure, so as to avoid occurrence of the connection trace between the blocking part and the first flange, and further avoid the influence of the connection trace on the connection strength, thereby reducing the possibility of fracture/cracking occurring between the blocking part and the first flange under the impact of the cooled medium.

Optionally, the blocking part is in a lath-shaped structure perpendicular to the first plate surface, or the blocking part is in a lath-shaped structure provided obliquely with respect to the first plate surface.

The beneficial effect of the technical solution is that: during processing, the first flange is cut to form the outline (profile) of the lath-shaped structure, and then stamped to make the lath-shaped structure bent to a position between the first flange and the protrusion part, and the processing difficulty is relatively low.

Optionally, the blocking part is a groove body, a groove opening (notch) of the groove body is formed on one side of the first flange facing away from the cooled medium flow channel, and a groove bottom of the groove body extends to the protrusion part.

The beneficial effect of this technical solution is that: the groove body can be formed by stamping on the first flange, and the flowing of the cooled medium is blocked by the outer wall of the groove body; the groove body can be in contact with the first flange at multiple points of the groove opening, so that the connection strength between the blocking part and the first flange is relatively high, enabling that it is not easily deformed under the impact of the cooled medium, improves the ability of the blocking part to block the cooled medium, and further reduces the proportion of the cooled medium that flows and deviates from the cooled medium flow channel; and the groove body can be formed by stamping, and the manufacturing process is relatively simple.

Optionally, the groove body is a V-shaped groove body or a U-shaped groove body.

Optionally, one blocking part is provided; or, at least two blocking parts are provided, and the individual blocking parts are distributed in the first direction.

The beneficial effect of this technical solution is that: this can form a multi-stage blocking for the cooled medium flowing to a position between the protrusion part and the first flange, so as to effectively reduce the proportion of the cooled medium that flows and deviates from the cooled medium flow channel, and when a plurality of blocking parts are arranged in the first direction, at least one blocking part can be correspondingly provided at each protrusion part.

Optionally, the chip has a second flange extending in the second direction, the second flange is formed on the first plate surface, and the second flange is located between the first flange and the cooled medium flow channel in the first direction.

The beneficial effect of this technical solution is that: before the cooled medium flows into the chip assembly through the second flange, the cooled medium that is to flow to between the protrusion part and the first flange can be blocked first, so as to reduce the proportion of the cooled medium flowing to between the protrusion part and the first flange, thereby correspondingly reducing the proportion of the cooled medium that flows and deviates from the cooled medium flow channel.

Optionally, the projection of the second flange in the first direction covers the protrusion part and the blocking part.

The beneficial effect of this technical solution is that this greatly increases the area of the second flange, further increases the blocking of the cooled medium that is to flow to between the protrusion part and the first flange, and reduces the proportion of the cooled medium that flows and deviates from the cooled medium flow channel.

Optionally, the second flange is connected to the first flange and the second flange and the first flange are sealed therebetween.

The beneficial effect of this technical solution is that: this makes it difficult for the cooled medium to flow from a position between the first flange and the second flange to a position between the protrusion part and the first flange, thereby reducing the proportion of the cooled medium that flows and deviates from the cooled medium flow channel.

Another aspect of the present disclosure provides a chip assembly, which comprises a first chip and a second chip that are superimposed with each other, the first chip is the chip provided by the present disclosure, and the first chip is lap-jointed on the second chip by the first flange.

Optionally, the second chip has a third flange lap-jointed on the first flange, the third flange is located on one side of the first flange facing the protrusion part in the second direction, and a through hole configured to allow the blocking part to pass therethrough is formed on the third flange.

The beneficial effect of this technical solution is that: it enables that the protrusion part can not only play the role of blocking the cooled medium, but also position the relative position of the first chip and the second chip when assembling the chip assembly, thereby improving the assembly accuracy and assembly efficiency.

Optionally, the second chip has a third flange lap-jointed on the first flange, and the third flange is located on one side of the first flange facing away from the protrusion part, in the second direction.

The beneficial effect of this technical solution is that: this enables that the protrusion part can not only play the role of blocking the cooled medium, but also eliminate the need to form on the third flange a through hole configured to allow the blocking part to pass therethrough, thereby simplifying the process steps of processing the through hole and improving the production efficiency.

Optionally, the blocking part is a groove body, the groove opening of the groove body is formed at the first flange, the groove bottom of the groove body extends to the protrusion part, and a support part extending into the groove body is formed on the third flange.

The beneficial effect of this technical solution is that: this enables that the blocking part can be more strongly supported by the support part when impacted by the cooled medium, so as to reduce the degree of deformation of the blocking part under the impact, thereby better blocking the cooled medium flowing to between the protrusion part and the first flange, and reducing the proportion of the cooled medium that flows and deviates from the cooled medium flow channel.

Optionally, the first chip has a second flange extending in the second direction, the second flange is formed on the first plate surface, and a fourth flange lap-jointed on the second flange is formed on the second chip.

The beneficial effect of this technical solution is that: the fourth flange is connected with the second flange, which can increase the bearing capacity of the second flange under the impact of the cooled medium, and reduce the probability of deformation of the second flange under the impact; in addition, the fourth flange is lap-jointed on the second flange, which can also position the relative positions of the first chip and the second chip when assembling the chip assembly, so as to improve assembly accuracy and efficiency.

Optionally, the first chip has a second plate surface provided facing away from the second chip, and the first chip has a first inter-group positioning part formed on the second plate surface.

Optionally, the first inter-group positioning part is an inter-group positioning protrusion protruding from the second plate surface.

The beneficial effect of this technical solution is that when a core (including multiple chip assemblies) is assembled, the inter-group positioning protrusion on the chip assembly can be matched/cooperated with the adjacent chip assembly for positioning, so as to improve the assembly efficiency and assembly accuracy of the core.

Optionally, the second chip has a third plate surface provided facing away from the first chip, and a second inter-group positioning part configured to be matched/cooperated with the inter-group positioning protrusion of adjacent chip assembly is formed on the third plate surface.

The beneficial effect of this technical solution is that: the assembly efficiency and assembly accuracy of the core are further improved by the second inter-group positioning part.

Optionally, the inter-group positioning protrusion is formed on the protrusion part.

The beneficial effect of this technical solution is that: this improves the utilization rate of the position occupied by the protrusion part and provides more sufficient space for arranging other structures on the first chip.

Optionally, the inter-group positioning protrusion has a port provided facing the second chip, the port forms an intra-group positioning part, and an intra-group positioning protrusion matching the intra-group positioning part is formed on the second chip.

The beneficial effect of this technical solution is that: the assembly efficiency of the chip assembly can be improved by the cooperation of the intra-group positioning part and the intra-group positioning protrusion.

A third aspect of the present disclosure provides a core, which comprises the chip assembly provided by the present disclosure.

A fourth aspect of the present disclosure provides an intercooler, which comprises the core provided by the present disclosure.

The technical solutions provided by the present disclosure can achieve the following beneficial effects.

For the chip, chip assembly and intercooler provided by the embodiments of the present disclosure, by forming the blocking part between the first flange and the protrusion part, the cooled medium that deviates from the cooled medium flow channel and flows to between the first flange and the protrusion part is blocked, so as to reduce the proportion of the cooled medium that flows and deviates from the cooled medium flow channel, so that the cooled medium and the cooling medium can exchange heat more fully, thereby improving the heat exchange performance of the intercooler.

### Brief Description of Drawings

In order to more clearly illustrate the technical solutions of the specific embodiments in the present disclosure, drawings which need to be used for description of the specific embodiments will be introduced briefly below, and apparently, the drawings in the following description show some embodiments of the present disclosure, and those ordinarily skilled in the art still could obtain other drawings in light of these accompanying drawings, without using any inventive efforts.
FIG. 1 to FIG. 3 are schematic views of a chip assembly according to an example not according to the present invention in three different viewing angles;
FIG. 4 is a section view of the chip assembly in FIG. 3 in an A-A direction;
FIG. 5 to FIG. 7 are schematic views of a chip provided by the present disclosure in three different viewing angles;
FIG. 8 is a schematic view of a second chip according to an embodiment of the present disclosure;
FIG. 9 to FIG. 14 are schematic views of cooperation between a first chip and the second chip according to several different embodiments provided by the present disclosure;
FIG. 15 is a schematic view of cooperation between the first chip of one chip assembly in two adjacent chip assemblies according to an embodiment of the present disclosure and the second chip of the other chip assembly; and
FIG. 16 is an enlarged view of part B in FIG. 15.

Reference signs in drawings: 100-first chip; 110-intra-group positioning part; 120-second flange; 130-protrusion part; 140-blocking part; 150-first plate surface; 160-first flange; 170-inter-group positioning protrusion; 180-second plate surface; 200-second chip; 210-intra-group positioning protrusion; 220-third flange; 221-through hole; 230-fourth flange; 240-third plate surface; 250-second inter-group positioning part; 260-support part; 270-fourth plate surface; 300-cooled medium flow channel.

### Detailed Description of Embodiments

In the intercooler, the distribution areas of the cooled medium flow channel and the cooling liquid flow channel on the chip should roughly be overlapped to improve the heat exchange performance. However, the inventors found that the intercooler in the related art, especially the water-air intercooler, has the problem of poor heat exchange performance, one of the reasons is that when the high-temperature gas passes through the core, the situation that some high-temperature gas deviates from the high-temperature gas flow channel often occurs, so that the high-temperature gas cannot fully exchange heat with the cooling liquid, which reduces the heat exchange performance of the intercooler.

In order to improve the above-mentioned deficiency of the existing intercooler, the present disclosure provides a chip, a chip assembly and an intercooler. By providing a blocking part on the chip, at least some cooled medium flowing to between the flange of the chip and the protrusion part is blocked, thereby reducing the proportion of the cooled medium that flows and deviates from the cooled medium flow channel.

In the description of the present disclosure, it should be noted orientation or positional relationships indicated by terms such as "center", "upper", "lower", "left", "right", "vertical", "horizontal", "inner", and "outer" are based on orientation or positional relationships as shown in the drawings, merely for facilitating the description of the present disclosure and simplifying the description, rather than indicating or implying that related devices or elements have to be in the specific orientation, or configured or operated in a specific orientation, therefore, they should not be construed as limitations on the present disclosure. Besides, terms "first", "second" and "third" are merely for descriptive purpose, but should not be construed as indicating or implying importance in relativity.

In the description of the present disclosure, it should be noted that, unless otherwise definitely specified and limited, the terms "mount", "link" and "connect" should be understood in a broad sense, for example, it can be fixed connection, detachable connection or integrated connection; it can be direct connection or indirect connection by intermediate medium, or it may be internal communication between two components. For those ordinarily skilled in the art, the specific meaning of the above terms in the present disclosure can be understood according to the specific situation.

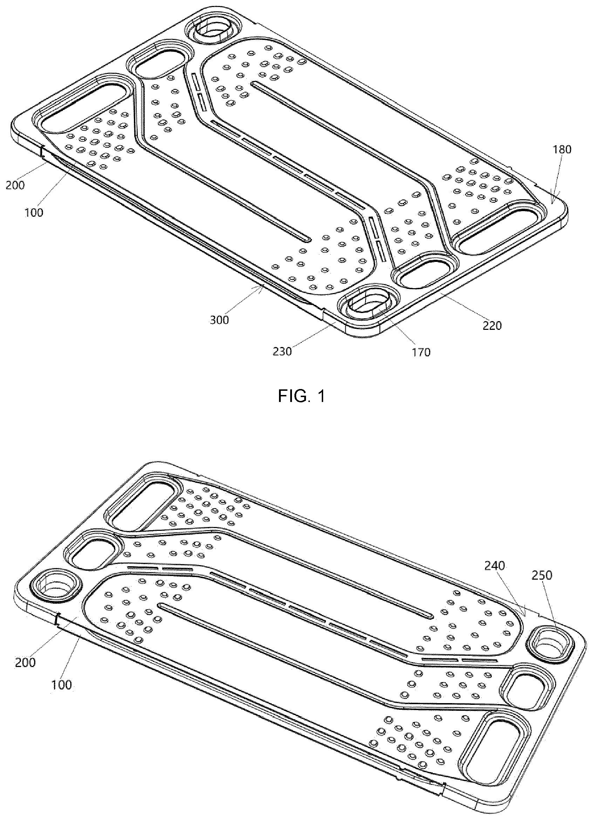

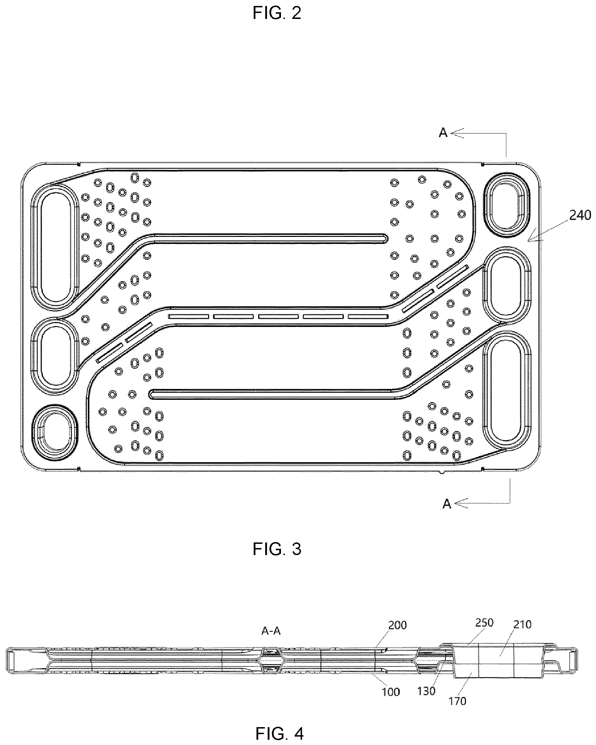

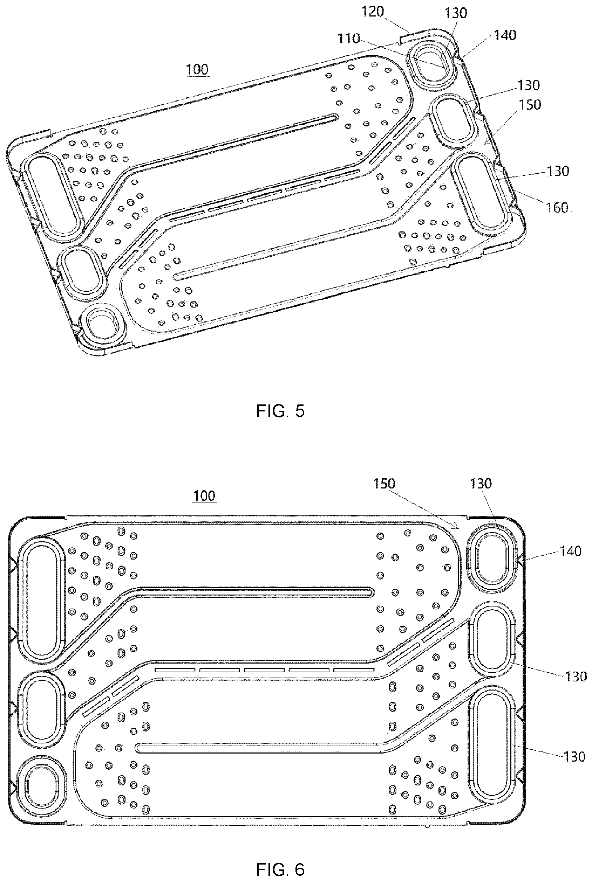

FIG. 1 to FIG. 3 are schematic views of a chip assembly according to an example not according to the invention in three different viewing angles; and FIG. 4 is a section view of the chip assembly in FIG. 3 in an A-A direction. As shown in FIG. 1 to FIG. 4, a chip assembly provided by the present disclosure includes a first chip 100 and a second chip 200 that are superimposed with each other, the first chip 100 is a chip provided by an embodiment of the present disclosure, and the first chip 100 is lap-jointed on the second chip 200 by the first flange 160. A cooled medium flow channel 300 for the cooled medium to circulate is formed between the first chip 100 and the second chip 200, and two surfaces of the first chip 100 and the second chip 200 facing away from each other are configured to be in contact with cooled medium. The mediums on the inner and outer sides of the cooling assembly perform heat exchange through the first chip 100 and the second chip 200. Generally, in a superimposed direction of the first chip 100 and the second chip 200, the cooled medium and the cooling medium have higher heat exchange efficiency when they are aligned with each other. Therefore, the first chip 100 of the embodiment of the present disclosure adopts the blocking part 140 (see FIG. 5) to reduce the amount of the cooled medium flowing from the cooled medium flow channel 300 to the edge part of the chip assembly, so as to improve the problem of poor heat exchange efficiency caused by the fact that the cooled medium and the cooling medium are not aligned in a thickness direction of the chip assembly. Both the cooling medium and the cooled medium in the embodiments of the present disclosure may be either liquid or gas.

FIG. 5 to FIG. 7 are schematic views of a chip provided by the present disclosure in three different viewing angles. The first chip 100 in the chip assembly provided by the embodiment of the present disclosure is the chip provided by the embodiments of FIG. 1 to FIG. 3, and the chip provided by the present disclosure will be described below by taking the first chip 100 as an example. As shown in FIG. 1 to FIG. 3, the first chip 100 provided by the embodiment of the present disclosure has a first flange 160 and a first plate surface 150 configured to be in contact with the cooled medium, and the first flange 160 is formed on the first plate surface 150 and extends in a first direction.

The first plate surface 150 of the first chip 100 is formed with protrusion parts 130 and a cooled medium flow channel 300 (see FIG. 1), each protrusion parts 130 are located between the first flange 160 and the cooled medium flow channel 300 in a second direction, blocking parts 140 configured to block the cooled medium are formed between the first flange 160 and the protrusion parts 130.

In the above, the first direction is an extending direction of the cooled medium flow channel 300, namely the up-down direction in FIG. 6; and the second direction is parallel to the first plate surface 150 and perpendicular to the first direction, namely the left-right direction in FIG. 6.

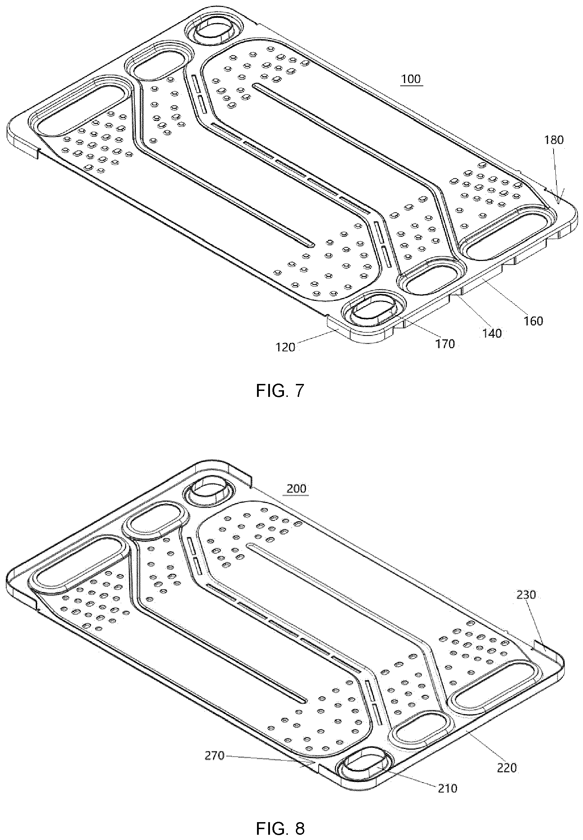

The above-mentioned protrusion part 130 can be configured to be fixedly connected with the protrusion part on the adjacent chip, and can also be configured to be matched/cooperate with the intra-group positioning protrusion 210 (see FIG. 8) on the adjacent chip; two ends of the first chip 100 can each be formed with a protrusion part 130 in a second direction, and the cooled medium flow channel 300 is formed between the two protrusion parts 130 arranged in the second direction. As shown in FIG. 2, two ends (left and right ends) of the first chip 100 in the second direction are respectively formed with a row of protrusion parts 130, and the two rows of protrusion parts 130 each include a plurality of protrusion parts 130 arranged in the first direction, the cooled medium flow channel 300 is formed between the two rows of protrusion parts 130.

In the first chip 100 provided by the embodiment of the present disclosure, the blocking part 140 is formed between the first flange 160 and the protrusion part 130, so as to form blocking for the cooled medium that deviates from the cooled medium flow channel 300 and flows to between the first flange 160 and the protrusion part 130, thereby reducing the proportion of the cooled medium that flows and deviates from the cooled medium flow channel 300, so that more cooled medium can flow in the cooled medium flow channel 300 of middle part of the first chip 100 as much as possible, so as to be aligned with the cooled medium on the other side of the first chip 100, so that the cooled medium and the cooling medium can exchange heat more fully and efficiently, and improve the heat exchange performance of the intercooler.

The blocking part 140 has one end connected to the first flange 160 and the other end connected to the protrusion part 130, in the second direction. In this way, most of the cooled medium flowing to between the first flange 160 and the protrusion part 130 can be blocked by the blocking part 140, thereby further reducing the proportion of the cooled medium that flows and deviates from the cooled medium flow channel 300.

Optionally, the first chip 100 has a second flange 120 extending in the second direction, the second flange 120 is formed on a first plate surface 150, and the second flange 120 is located between the first flange 160 and the cooled medium flow channel 300 in the first direction. Before the cooled medium flows into the chip assembly through the second flange 120, the cooled medium that is to flow to between the protrusion part 130 and the first flange 160 can be blocked first, so as to reduce the proportion of the cooled medium flowing to between the protrusion part 130 and the first flange 160, thereby correspondingly reducing the proportion of the cooled medium that flows and deviates from the cooled medium flow channel 300.

Optionally, the projection of the second flange 120 in the first direction covers the protrusion parts 130 and the blocking parts 140. This greatly increases the area of the second flange 120, further increases the blocking of the cooled medium that is to flow to between the protrusion part 130 and the first flange 160, and reduces the proportion of the cooled medium that flows and deviates from the cooled medium flow channel 300.

Optionally, the second flange 120 is connected to the first flange 160 and sealing is achieved between the second flange 120 and the first flange 160. This makes it difficult for the cooled medium to flow from a position between the first flange 160 and the second flange 120 to a position between the protrusion part 130 and the first flange 160, thereby reducing the proportion of the cooled medium that flows and deviates from the cooled medium flow channel 300; the connection between the second flange 120 and the first flange 160 may be connected by integral molding, or the second flange 120 and the first flange 160 may also be connected with each other after being separated.

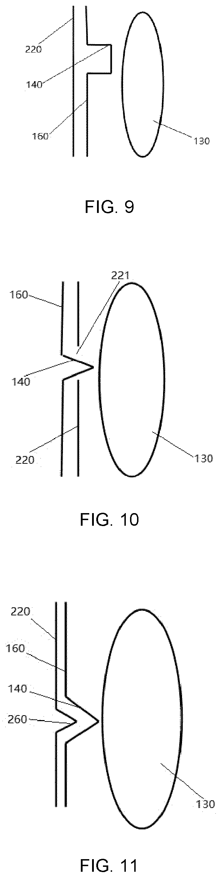

FIG. 8 is a schematic view of the second chip 200 according to an embodiment of the present disclosure; and FIG. 9 to FIG. 14 are schematic views of cooperation between the first chip 100 and the second chip 200 according to several different embodiments provided by the present disclosure. As shown in FIG. 8, the second chip 200 has a third flange 220 lap-jointed on the first flange 160. Optionally, in the case that the first chip 100 cooperates with the second chip 200, the third flange 220 is located on one side of the first flange 160 facing the protrusion part 130 in the second direction, as shown in FIG. 10, FIG. 13 and FIG. 16. In this case, a through hole 221 configured to allow the blocking part 140 to pass therethrough can be formed on the third flange 220, as shown in FIG. 10, so that the blocking part 140 can not only play the role of blocking the cooled medium, but also position the relative position between the first chip 100 and the second chip 200 when assembling the chip assembly, thereby improving the assembly accuracy and assembly efficiency.

Optionally, the second chip 200 has a third flange 220 lap-jointed on the first flange 160, and the third flange 220 is located on one side of the first flange 160 facing away from the protrusion part 130 in the second direction. This enables that the protrusion part 130 can not only play the role of blocking the cooled medium, but also eliminate the need to form on the third flange 220 a through hole 221 configured to allow the blocking part 140 to pass therethrough, thereby simplifying the process steps of processing the through hole 221 and improving the production efficiency.

Optionally, the blocking part 140 is a groove body, a groove opening of the groove body is formed on one side of the first flange 160 facing away from the cooled medium flow channel 300, a groove bottom of the groove body extends to the protrusion part 130, a support part 260 extending into the groove body is formed on the third flange 220. This enables that the blocking part 140 can be more strongly supported by the support part 260 when impacted by the cooled medium, so as to reduce the degree of deformation of the blocking part 140 under the impact, thereby better blocking the cooled medium flowing to between the protrusion part 130 and the first flange 160, and reducing the proportion of the cooled medium that flows and deviates from the cooled medium flow channel 300.

Optionally, the first chip 100 has a second flange 120 extending in a second direction, the second flange 120 is formed on the first plate surface 150, the fourth flange 230 lap-jointed on the second flange 120 is formed on the second chip 200. The fourth flange 230 is connected with the second flange 120, which can increase the bearing capacity of the second flange 120 under the impact of the cooled medium, and reduce the probability of deformation of the second flange 120 under the impact; and in addition, the fourth flange 230 is lap-jointed on the second flange 120, which can also position the relative positions of the first chip 100 and the second chip 200 when assembling the chip assembly, so as to improve assembly accuracy and efficiency.

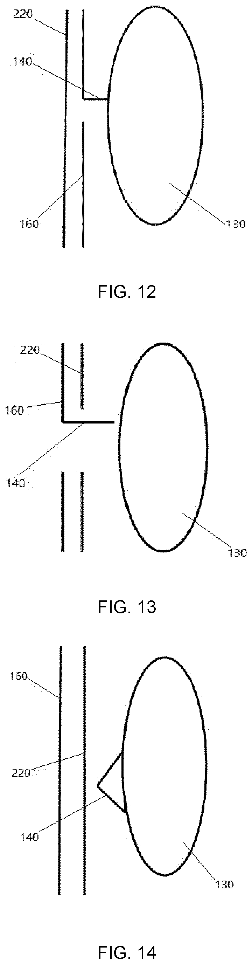

In the embodiment of the present disclosure, optionally, the blocking part 140 is formed on the first flange 160. This makes the blocking part 140 and the first flange 160 be in an integrally-formed structure, so as to avoid connection trace occurring between the blocking part 140 and the first flange 160, further avoid the influence of the connection trace on the connection strength, thereby reducing the possibility of breakage occurring between the blocking part 140 and the first flange 160 under the impact of the cooled medium. Of course, as shown in FIG. 14, the blocking part 140 can also be formed on the protrusion part 130.

As shown in FIG. 12 and FIG. 13, optionally, the blocking part 140 is a lath-shaped structure perpendicular to the first plate surface 150, or the blocking part 140 is a lath-shaped structure provided obliquely relative to the first plate surface 150. During processing, the first flange 160 is cut to form the outline of the lath-shaped structure, and then stamped to make the lath-shaped structure bent to between the first flange 160 and the protrusion part 130, and the processing difficulty is relatively low.

Optionally, the blocking part 140 is a groove body, a groove opening of the groove body is formed on the first flange 160, and a groove bottom of the groove body extends to the protrusion part 130. The groove body can be formed by stamping on the first flange 160, and the flowing of the cooled medium is blocked by the outer wall of the groove body; the groove body can be in contact with the first flange 160 at multiple points of the groove opening, so that the connection strength between the blocking part 140 and the first flange 160 is relatively high, so that it is not easily deformed under the impact of the cooled medium, improves the ability of the blocking part 140 to block the cooled medium, and further reduces the proportion of the cooled medium that flows and deviates from the cooled medium flow channel 300; and the groove body can be formed by stamping, and the manufacturing process is relatively simple.

As shown in FIG. 9 to FIG. 11 and FIG. 14, optionally, the groove body is a V-shaped groove body or a U-shaped groove body.

Optionally, one blocking part 140 is provided; or, at least two blocking parts 140 are provided, and the individual blocking parts 140 are distributed in the first direction. This can form a multi-stage blocking for the cooled medium flowing to between the protrusion part 130 and the first flange 160, so as to effectively reduce the proportion of the cooled medium that flows and deviates from the cooled medium flow channel 300, and when a plurality of blocking parts 140 are arranged in the first direction, at least one blocking part 140 can be correspondingly provided at each protrusion part 130.

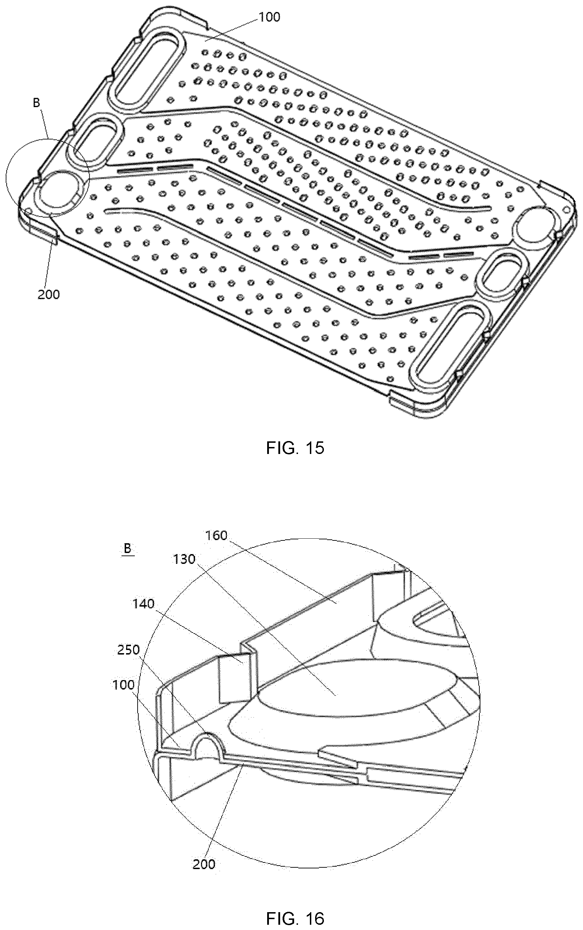

FIG. 15 is a schematic view of cooperation between the first chip 100 of one chip assembly in two adjacent chip assemblies according to an embodiment of the present disclosure and the second chip 200 of the other chip assembly; and FIG. 16 is an enlarged view of part B in FIG. 15. Referring to FIG. 15 and FIG. 16 in combination with FIG. 1 and FIG. 2, optionally, the first chip 100 has a second plate surface 180 provided facing away from the second chip 200, and the first chip 100 has a first inter-group positioning part formed on the second plate surface. The first inter-group positioning part is an inter-group positioning protrusion 170 protruding from the second plate surface 180.

When a core (including multiple chip assemblies) is assembled, the inter-group positioning protrusion 170 on the chip assembly can cooperation/be matched with the adjacent chip assembly for positioning, so as to improve the assembly efficiency and assembly accuracy of the core.

Optionally, the second chip 200 has a third plate surface 240 provided facing away from the first chip 100, a second inter-group positioning part 250 configured to match with the inter-group positioning protrusion 170 of adjacent chip assembly is formed on the third plate surface 240. The assembly efficiency and assembly accuracy of the core are further improved by the second inter-group positioning part 250. Of course, as shown in FIG. 10, the second inter-group positioning part 250 can also be in a protrusion structure, and the first inter-group positioning part is in a through-hole structure, so that the protrusion structure is matched with the through hole structure to perform the positioning between two adjacent chip assemblies.

Optionally, the inter-group positioning protrusion 170 is formed on the protrusion part 130. This improves the utilization rate of the position occupied by the protrusion part 130 and provides more sufficient space for arranging other structures on the first chip 100.

Optionally, the inter-group positioning protrusion 170 has a port provided facing the second chip 200, the port forms the intra-group positioning part 110, and an intra-group positioning protrusion 210 matching the intra-group positioning part 110 are formed on the second chip 200. The assembly efficiency of the chip assembly can be improved by cooperation of the intra-group positioning part 110 and the intra-group positioning protrusion 210. The inter-group positioning protrusion 170 can be a groove body with a groove opening located on the protrusion part 130, and the intra-group positioning part 110 is formed at the groove opening, so that the intra-group positioning part 110 can be formed while the inter-group positioning protrusion 170 is processed, thereby improving production efficiency. The second chip 200 has a fourth plate surface 270 provided facing the first chip 100, and the intra-group positioning protrusion 210 may be located on the fourth plate surface 270.

The present disclosure provides a core, which includes a plurality of chip assemblies provided by the present disclosure, and the plurality of chip assemblies are assembled together for allowing circulation of a cooling medium and a cooled medium. The core provided by the present disclosure can be used to constitute an intercooler provided by the present disclosure.

To sum up, the chip assembly provided by the embodiment of the present disclosure uses the chips provided by the embodiment of the present disclosure. By forming the blocking part 140 between the first flange 160 and the protrusion part 130, the cooled medium that deviates from the cooled medium flow channel 300 and flows to between the first flange 160 and the protrusion part 130 is blocked, so as to reduce the proportion of the cooled medium that flows and deviates from the cooled medium flow channel 300, so that the cooled medium and the cooling medium can exchange heat more fully, thereby improving the heat exchange performance of the intercooler.

The intercooler provided by the present disclosure includes the core provided by the embodiment of the present disclosure.

The intercooler provided by the embodiment of the present disclosure adopts the core (including a plurality of chip assemblies) provided by the embodiment of the present disclosure, wherein by forming the blocking part 140 between the first flange 160 and the protrusion part 130, the cooled medium that deviates from the cooled medium flow channel 300 and flows to between the first flange 160 and the protrusion part 130 is blocked, so as to reduce the proportion of the cooled medium that flows and deviates from the cooled medium flow channel 300, so that the cooled medium and the cooling medium can exchange heat more fully, thereby improving the heat exchange performance of the intercooler.

### Industrial Applicability

A chip, chip assembly, core and intercooler provided by the present disclosure can reduce the proportion of the cooled medium that flows and deviates from the cooled medium flow channel by the blocking part, so that the cooled medium and the cooling medium can exchange heat more fully, thereby improving the heat exchange performance of the intercooler.

## Claims

1. A chip, wherein the chip has a first flange (160) and a first plate surface (150) configured to be in contact with a cooled medium, the first flange (160) is formed on the first plate surface (150) and extends in a first direction;
at least one protrusion part (130) and a cooled medium flow channel (300) are formed on the first plate surface (150), the at least one protrusion part (130) is located between the first flange (160) and the cooled medium flow channel (300) in a second direction, at least one blocking part (140) configured to block the cooled medium is formed between the first flange (160) and the at least one protrusion part (130); and
the first direction is an extension direction of the cooled medium flow channel (300), and the second direction is parallel to the first plate surface (150) and is perpendicular to the first direction;
**characterized in that**, wherein the at least one blocking part (140) has one end connected to the first flange (160), and the other end connected to the at least one protrusion part (130), in the second direction.

2. The chip according to claim 1, wherein the at least one blocking part (140) is formed on the first flange (160).

3. The chip according to claim 2, wherein the at least one blocking part (140) is in a lath-shaped structure perpendicular to the first plate surface (150).

4. The chip according to claim 2, wherein the at least one blocking part (140) is a groove body, a groove opening of the groove body is formed on one side of the first flange (160) facing away from the cooled medium flow channel (300), and a groove bottom of the groove body extends to the at least one protrusion part (130).

5. The chip according to any one of claims 1-4, wherein one blocking part (140) is provided; or, at least two blocking parts (140) are provided, and the individual blocking parts (140) are distributed in the first direction.

6. The chip according to any one of claims 1-5, wherein the chip has a second flange (120) extending in the second direction, the second flange (120) is formed on the first plate surface (150), and the second flange (120) is located between the first flange (160) and the cooled medium flow channel (300) in the first direction.

7. A chip assembly, **characterized by** comprising a first chip (100) and a second chip that are superimposed with each other, the first chip (100) is the chip according to any one of claims 1-6, and the first chip (100) is lap-jointed on the second chip by the first flange (160).

8. The chip assembly according to claim 8, wherein the second chip has a third flange (220) lap-jointed on the first flange (160), the third flange (220) is located on one side of the first flange (160) facing the at least one protrusion part (130) in the second direction, and at least one through hole (221) configured to allow the at least one blocking part (140) to pass therethrough is formed on the third flange (220).

9. The chip assembly according to any one of claims 7-8, wherein the first chip (100) has a second flange (120) extending in the second direction, the second flange (120) is formed on the first plate surface (150), and a fourth flange (230) lap-jointed on the second flange (120) is formed on the second chip.

10. The chip assembly according to any one of claims 7-9, wherein the first chip (100) has a second plate surface provided facing away from the second chip, and the first chip (100) has a first inter-group positioning part formed on the second plate surface.

11. The chip assembly according to claim 10, wherein the second chip has a third plate surface (240) provided facing away from the first chip (100), and a second inter-group positioning part (250) configured to be matched with the inter-group positioning protrusion of an adjacent chip assembly is formed on the third plate surface (240).

12. The chip assembly according to claim 10, wherein the inter-group positioning protrusion is formed on the at least one protrusion part (130),
the inter-group positioning protrusion has a port provided facing the second chip, the port forming an intra-group positioning part (110), and an intra-group positioning protrusion (210) matching the intra-group positioning part (110) is formed on the second chip.

13. A core, **characterized by** comprising the chip assembly according to any one of claims 7-12.

14. An intercooler, **characterized by** comprising the core according to claim 13.

## Patentansprüche

1. Chip, wobei der Chip einen ersten Flansch (160) und eine erste Plattenoberfläche (150) aufweist, die dazu ausgestaltet ist, mit einem gekühlten Medium in Kontakt zu sein, wobei der erste Flansch (160) auf der ersten Plattenoberfläche (150) gebildet ist und sich in eine erste Richtung erstreckt;
mindestens ein Vorsprungsteil (130) und ein Strömungskanal (300) für gekühltes Medium auf der ersten Plattenoberfläche (150) gebildet sind, wobei der mindestens eine Vorsprungsteil (130) sich zwischen dem ersten Flansch (160) und dem Strömungskanal (300) für gekühltes Medium in einer zweiten Richtung befindet, wobei mindestens ein Blockierteil (140), das dazu ausgestaltet ist, das gekühlte Medium zu blockieren, zwischen dem ersten Flansch (160) und dem mindestens einen Vorsprungsteil (130) gebildet ist; und
die erste Richtung eine Erstreckungsrichtung des Strömungskanals (300) für gekühltes Medium ist, und die zweite Richtung parallel zur ersten Plattenoberfläche (150) ist und senkrecht zur ersten Richtung ist;
**dadurch gekennzeichnet, dass** der mindestens eine Blockierteil (140) ein Ende, das mit dem ersten Flansch (160) verbunden ist, und das andere Ende aufweist, das mit dem mindestens einen Vorsprungsteil (130) in der zweiten Richtung verbunden ist.

2. Chip nach Anspruch 1, wobei der mindestens eine Blockierteil (140) auf dem ersten Flansch (160) gebildet ist.

3. Chip nach Anspruch 2, wobei der mindestens eine Blockierteil (140) eine leistenförmige Struktur senkrecht zur ersten Plattenoberfläche (150) ist.

4. Chip nach Anspruch 2, wobei der mindestens eine Blockierteil (140) ein Rillenkörper ist, eine Rillenöffnung des Rillenkörpers auf einer Seite des ersten Flanschs (160) gebildet ist, die von dem Strömungskanal (300) für gekühltes Medium abgewandt ist, und ein Rillenboden des Rillenkörpers sich zu dem mindestens einen Vorsprungsteil (130) erstreckt.

5. Chip nach einem der Ansprüche 1 bis 4, wobei ein Blockierteil (140) bereitgestellt ist; oder mindestens zwei Blockierteile (140) bereitgestellt sind, und die einzelnen Blockierteile (140) in der ersten Richtung verteilt sind.

6. Chip nach einem der Ansprüche 1 bis 5, wobei der Chip einen zweiten Flansch (120) aufweist, der sich in der zweiten Richtung erstreckt, wobei der zweite Flansch (120) auf der ersten Plattenoberfläche (150) gebildet ist, und der zweite Flansch (120) sich zwischen dem ersten Flansch (160) und dem Strömungskanal (300) für gekühltes Medium in der ersten Richtung befindet.

7. Chipanordnung, **dadurch gekennzeichnet, dass** sie einen ersten Chip (100) und einen zweiten Chip umfasst, die miteinander übereinandergelagert sind, wobei der erste Chip (100) der Chip nach einem der Ansprüche 1 bis 6 ist, und der erste Chip (100) durch den ersten Flansch (160) auf dem zweiten Chip überlappt ist.

8. Chipanordnung nach Anspruch 8, wobei der zweite Chip einen dritten Flansch (220) aufweist, der auf dem ersten Flansch (160) überlappt ist, wobei der dritte Flansch (220) sich auf einer Seite des ersten Flanschs (160) befindet, die dem mindestens einen Vorsprungsteil (130) in der zweiten Richtung zugewandt ist, und mindestens ein Durchgangsloch (221), das dazu ausgestaltet ist, den Durchgang des mindestens einen Blockierteils (140) dort hindurch zu ermöglichen, an dem dritten Flansch (220) gebildet ist.

9. Chipanordnung nach einem der Ansprüche 7 bis 8, wobei der erste Chip (100) einen zweiten Flansch (120) aufweist, der sich in der zweiten Richtung erstreckt, wobei der zweite Flansch (120) auf der ersten Plattenoberfläche (150) gebildet ist, und ein vierter Flansch (230), der auf dem zweiten Flansch (120) überlappt ist, auf dem zweiten Chip gebildet ist.

10. Chipanordnung nach einem der Ansprüche 7 bis 9, wobei der erste Chip (100) eine zweite Plattenoberfläche aufweist, die von dem zweiten Chip abgewandt bereitgestellt ist, und der erste Chip (100) einen ersten Zwischengruppen-Positionierungsteil aufweist, der auf der zweiten Plattenoberfläche gebildet ist.

11. Chipanordnung nach Anspruch 10, wobei der zweite Chip eine dritte Plattenoberfläche (240) aufweist, die von dem ersten Chip (100) abgewandt bereitgestellt ist, und ein zweiter Zwischengruppen-Positionierungsteil (250), der dazu ausgestaltet ist, mit dem Zwischengruppen-Positionierungsvorsprung einer benachbarten Chipanordnung zusammenzupassen, auf der dritten Plattenoberfläche (240) gebildet ist.

12. Chipanordnung nach Anspruch 10, wobei der Zwischengruppen-Positionierungsvorsprung auf dem mindestens einen Vorsprungsteil (130) gebildet ist,
der Zwischengruppen-Positionierungsvorsprung eine Öffnung aufweist, die dem zweiten Chip zugewandt bereitgestellt ist, wobei die Öffnung einen gruppeninternen Positionierungsteil (110) bildet, und ein gruppeninterner Positionierungsvorsprung (210), der mit dem gruppeninternen Positionierungsteil (110) zusammenpasst, auf dem zweiten Chip gebildet ist.

13. Kern, **dadurch gekennzeichnet, dass** er die Chipanordnung nach einem der Ansprüche 7 bis 12 umfasst.

14. Zwischenkühler, **dadurch gekennzeichnet, dass** er den Kern nach Anspruch 13 umfasst.

## Revendications

1. Puce, dans laquelle la puce a une première bride (160) et une première surface de plaque (150) configurée pour être en contact avec un milieu refroidi, la première bride (160) est formée sur la première surface de plaque (150) et s'étend dans une première direction ;
au moins une partie de saillie (130) et un canal d'écoulement de milieu refroidi (300) sont formés sur la première surface de plaque (150), la au moins une partie de saillie (130) est positionnée entre la première bride (160) et le canal d'écoulement de milieu refroidi (300) dans une seconde direction, au moins une partie de blocage (140) configurée pour bloquer le milieu refroidi est formée entre la première bride (160) et la au moins une partie de saillie (130) ; et
la première direction est une direction d'extension du canal d'écoulement de milieu refroidi (300), et la seconde direction est parallèle à la première surface de plaque (150) et est perpendiculaire à la première direction ;
**caractérisée en ce que**, la au moins une partie de blocage (140) a une extrémité raccordée à la première bride (160), et l'autre extrémité raccordée à la au moins une partie de saillie (130), dans la seconde direction.

2. Puce selon la revendication 1, dans laquelle la au moins une partie de blocage (140) est formée sur la première bride (160).

3. Puce selon la revendication 2, dans laquelle la au moins une partie de blocage (140) est une structure en forme de latte perpendiculaire à la première surface de plaque (150).

4. Puce selon la revendication 2, dans laquelle le au moins une partie de blocage (140) est un corps de rainure, une ouverture de rainure du corps de rainure est formée sur un côté de la première bride (160) orienté à l'opposé du canal d'écoulement de milieu refroidi (300), et un fond de rainure du corps de rainure s'étend vers la au moins une partie de saillie (130) .

5. Puce selon l'une quelconque des revendications 1 à 4, dans laquelle une partie de blocage (140) est prévue ; ou au moins deux parties de blocage (140) sont prévues, et les parties de blocage (140) individuelles sont réparties dans la première direction.

6. Puce selon l'une quelconque des revendications 1 à 5, dans laquelle la puce a une deuxième bride (120) s'étendant dans la seconde direction, la deuxième bride (120) est formée sur la première surface de plaque (150) et la deuxième bride (120) est positionnée entre la première bride (160) et le canal d'écoulement de milieu refroidi (300) dans la première direction.

7. Ensemble de puces, **caractérisé en ce qu'**il comprend une première puce (100) et une seconde puce qui sont superposées l'une sur l'autre, la première puce (100) est la puce selon l'une quelconque des revendications 1 à 6, et la première puce (100) est jointée par recouvrement sur la seconde puce par la première bride (160).

8. Ensemble de puces selon la revendication 8, dans lequel la seconde puce a une troisième bride (220) jointée par recouvrement sur la première bride (160), la troisième bride (220) est positionnée d'un côté de la première bride (160) faisant face à la au moins une partie de saillie (130) dans la seconde direction, et au moins un trou débouchant (221) configuré pour permettre à la au moins une partie de blocage (140) de passer à travers ce dernier, est formé sur la troisième bride (220).

9. Ensemble de puces selon l'une quelconque des revendications 7 à 8, dans lequel la première puce (100) a une deuxième bride (120) s'étendant dans la seconde direction, la deuxième bride (120) est formée sur la première surface de plaque (150), et une quatrième bride (230) jointée par recouvrement sur la deuxième bride (120) est formée sur la seconde puce.

10. Ensemble de puces selon l'une quelconque des revendications 7 à 9, dans lequel la première puce (100) a une deuxième surface de plaque prévue en étant orientée à l'opposé de la seconde puce, et la première puce (100) a une première partie de positionnement intergroupe formée sur la deuxième surface de plaque.

11. Ensemble de puces selon la revendication 10, dans lequel la seconde puce a une troisième surface de plaque (240) prévue en étant orientée à l'opposé de la première puce (100), et une seconde partie de positionnement intergroupe (250) configurée pour correspondre à la saillie de positionnement intergroupe d'un ensemble de puces adjacent est formée sur la troisième surface de plaque (240).

12. Ensemble de puces selon la revendication 10, dans lequel la saillie de positionnement intergroupe est formée sur la au moins une partie de saillie (130),
la saillie de positionnement intergroupe a un orifice prévu en face de la seconde puce, l'orifice formant une partie de positionnement intergroupe (110), et une saillie de positionnement intergroupe (210) correspondant à la partie de positionnement intergroupe (110) est formée sur la seconde puce.

13. Noyau **caractérisé en ce qu'**il comprend l'ensemble de puces selon l'une quelconque des revendications 7 à 12.

14. Refroidisseur intermédiaire **caractérisé en ce qu'**il comprend le noyau selon la revendication 13.
